# EUROPÄISCHE PATENTSCHRIFT

(11) **EP 2 700 105 B1**
(45) Veröffentlichungstag und Bekanntmachung des Hinweises auf die Patenterteilung: **30.11.2016**
(21) Anmeldenummer: 12722066.3
(22) Anmeldetag: 10.04.2012
(51) Int. Cl.: H01L 31/052

(54) **SOLARVORRICHTUNG**
SOLAR DEVICE
DISPOSITIF SOLAIRE

(30) Priorität: 21.04.2011 DE 102011002217; 01.07.2011 DE 102011051507
(43) Veröffentlichungstag der Anmeldung: 26.02.2014
(73) Patentinhaber: BPE e. K., 90542 Eckental (DE)
(72) Erfinder: HORNIG, Wolfgang, 90542 Eckental (DE)
(74) Vertreter: Kaufmann, Sigfrid
(86) Internationale Anmeldenummer: PCT/DE2012/100098
(87) Internationale Veröffentlichungsnummer: WO 2012/143003

(56) Entgegenhaltungen:
- DE-A1- 3 704 559
- DE-A1- 10 122 679
- DE-A1-102006 014 414
- DE-A1-102007 055 462
- DE-A1-102008 009 477
- DE-A1-102010 019 782
- GB-A- 2 321 338
- GB-A- 2 473 447
- JP-A- 4 046 900
- JP-A- 2007 166 721
- JP-A- 2007 278 669
- JP-A- 2009 283 881
- US-A- 5 409 550

## Beschreibung

Die Erfindung betrifft eine Solarvorrichtung zum Umwandeln von Solarenergie in elektrische Energie, z.B. zum Versorgen eines Gebäudes mit elektrischer Energie.

Derartige Solarvorrichtungen können beispielsweise in Form von Photovoltaikmodulen zum Umwandeln von Solarenergie in elektrische Energie vorliegen und werden - z.B. auf dem Dach eines Gebäudes - derart installiert, dass sie tagsüber der Sonneneinstrahlung ausgesetzt sind, wodurch eine Erwärmung der Solarvorrichtungen eintritt. Bei Photovoltaikanlagen bzw. Solarzellen nimmt mit zunehmender Temperatur der Wirkungsgrad bzw. die Stromausbeute ab, sodass eine solche Erwärmung eher unerwünscht ist.

Um ein zu starkes Erhitzen von Photovoltaikanlagen zu vermeiden, können solche Anlagen gekühlt werden, z.B. mittels Hinterlüftens oder mittels einer Flüssigkühlung. Eine Kombination einer Photovoltaikanlage mit einer Flüssigkeitskühlung ermöglicht gleichzeitig das Kühlen der Photovoltaikanlage, wobei deren Stromausbeute erhöht wird, und das Erwärmen der Kühlflüssigkeit, wobei die erwärmte Kühlflüssigkeit z.B. zum Beheizen eines Gebäudes oder auch - im Falle von Wasser als Kühlflüssigkeit - direkt als Warmwasser verwendet werden kann.

Die DE 10 2004 002 900 A1 beschreibt ein Photovoltaikmodul, welches mittels einer Kühlflüssigkeit, die durch einen Kühlkreislauf mit einem Wärmetauscher geleitet wird, gekühlt wird; wobei unter Verwendung von Wasser als Kühlflüssigkeit die gleichzeitige Gewinnung von Warmwasser beschrieben ist.

Die DE 20 2008 004 965 U1 beschreibt ein Thermoelement für ein Photovoltaikmodul, wobei das Thermoelement, welches gleichzeitig als Sonnenkollektor wirkt, Kanäle zum Durchleiten eines flüssigen Kühl- oder Heizmediums aufweist und zum Abkühlen oder Anwärmen des Photovoltaikmoduls verwendet werden kann.

In GB 2 473 447 A ist eine Kachel offenbart, welche zusätzlich Fluidleitungen intergiert haben kann, um Wasser mittels Sonnenenergie zu erwärmen. Ebenso kann diese Kachel ein Photovoltaikmodul zum Umwandeln von Solarenergie in elektrische Energie oder ein Peltierelement zum Umwandlen von thermischer in elektrische Energie aufweisen.

Sowohl bei Photovoltaikmodulen zur ausschließlichen Gewinnung elektrischer Energie als auch bei thermischen Solarkollektoren zur ausschließlichen Gewinnung thermischer Energie und bei Kombinationen von Photovoltaikmodulen mit Solarkollektoren (z.B. als Kühlvorrichtung) geht - aufgrund von Temperaturdifferenzen zwischen den jeweiligen von der Sonnenstrahlung erwärmten Bauteilen und der Außenumgebung - stets ein Teil der eingestrahlten Energie als nicht genutzte Abwärme verloren.

Die DE 10 2007 055 462 A1 beschreibt eine Photovoltaik-Anlage mit einer Solarzelle und einem Peltierelement, wobei das Peltierelement mittels Anlegens einer Spannung daran zur Kühlung und/oder Beheizung der Solarzelle verwendet werden kann.

Durch die Erfindung wird eine Solarvorrichtung zum Umwandeln von Solarenergie in elektrische Energie bereitgestellt, mittels derer ein hoher Wirkungsgrad (d.h. ein hohes Verhältnis von eingestrahlter Solarenergie zu daraus gewonnener Nutzenergie) erzielt werden kann.

Durch die Erfindung wird eine Solarvorrichtung gemäß dem Anspruch 1 bereitgestellt, Ausführungsformen der Erfindung ergeben sich aus den abhängigen Ansprüchen.

Gemäß der Erfindung wird eine Solarvorrichtung mit einem Solarelement, das zum Umwandeln von Solarenergie in elektrische Energie ausgebildet ist, bereitgestellt, wobei die Solarvorrichtung ferner ein Peltierelement aufweist, das im thermischen Kontakt mit dem Solarelement angeordnet ist. Das Peltierelement weist eine erste und eine zweite Thermokontakt-Fläche auf, wobei die Thermokontakt-Flächen (im Folgenden auch kurz als "Thermoflächen" bezeichnet) zum thermischen Kontaktieren des Peltierelements dienen. Die Solarvorrichtung weist zudem einen Temperatursensor und/oder einen Lichtsensor auf und ist zum derartigen Beaufschlagen des Peltierelements mit einem elektrischen Strom ausgebildet, dass das Peltierelement als Wärmepumpe zum selektiven Heizen und Kühlen (d.h. wahlweisen Heizen oder Kühlen) des Solarelements betrieben werden kann. Des Weiteren ist die Solarvorrichtung derart ausgebildet, dass das Peltierelement auch als thermoelektrischer Generator zum Erzeugen einer elektrischen Spannung betrieben werden kann und die erzeugte Spannung über die Anschlusselektroden des Peltierelements abgegriffen werden kann, und weist eine Steuereinheit auf, die derart eingerichtet ist, dass von ihr basierend auf der von dem Temperatursensor erfassten Temperatur und/oder der von dem Lichtsensor erfassten Lichtintensität die Funktionalität des Peltierelements derart variiert werden kann, dass das Peltierelement selektiv entweder als thermoelektrischer Generator zum Erzeugen einer elektrischen Spannung oder als Wärmepumpe zum selektiven Heizen und Kühlen des Solarelements betrieben werden kann.

Indem das Peltierelement im thermischen Kontakt mit dem Solarelement angeordnet ist, kann (wenn das Peltierelement als thermoelektrischer Generator betrieben wird) die Temperaturdifferenz zwischen dem - z.B. von der Solarstrahlung erwärmten - Solarelement und der Außenumgebung zum Erzeugen eines elektrischen Stromes (bzw. einer Spannung) mittels des Peltierelements genutzt werden und somit der Gesamtwirkungsgrad der Solarvorrichtung gesteigert werden. Zudem kann das Peltierelement als Wärmesenke bzw. Kühlvorrichtung zum Kühlen des Solarelements wirken, indem von dem Peltierelement Wärmeenergie in elektrische Energie umgewandelt und in Form von elektrischem Strom abgeführt wird. Durch eine solche Kühlung kann z.B. zusätzlich die Stromausbeute eines als Photovoltaikelement ausgeführten Solarelements erhöht werden und die thermische Degradation eines solchen Solarelements verringert und somit dessen Lebensdauer verlängert werden. Durch den kombinierten Effekt der Kühlung eines Solarelements in Form eines Photovoltaikelements und der zusätzlichen Stromerzeugung durch das Peltierelement sind - bezogen auf die Stromausbeute eines entsprechenden Photovoltaikelements ohne Peltierelement - Leistungssteigerungen im zweistelligen Prozentbereich möglich.

Ein Peltierelement ist ein elektrothermischer Wandler, der - basierend auf dem Peltiereffekt - bei Stromdurchfluss eine Temperaturdifferenz (zwischen seinen beiden Thermoflächen) erzeugt oder aber - basierend auf dem Seebeckeffekt als Umkehrung des Peltiereffekts - bei Vorliegen einer Temperaturdifferenz zwischen den beiden Thermoflächen einen Stromfluss zwischen zwei entsprechenden Anschlusselektroden des Peltierelements erzeugt. Im letzteren Fall wirkt das Peltierelement somit als thermoelektrischer Generator. Das Peltierelement der Solarvorrichtung kann ein einstufiges oder ein mehrstufiges Peltierelement sein.

Das Solarelement kann z.B. ein Photovoltaikelement bzw. eine Solarzelle zum Aufnehmen von Solarenergie und Umwandeln derselben in elektrische Energie sein. Das Solarelement kann jedoch auch eine Kombination eines Photovoltaikelements und eines thermischen Solarkollektors sein, wobei der Solarkollektor z.B. gleichzeitig zum Kühlen des Photovoltaikelements vorgesehen sein kann. Des Weiteren kann das Solarelement z.B. ein Spiegel bzw. Reflektor der Solarvorrichtung sein, z.B. ein als optischer Konzentrator wirkender Reflektor, mittels dessen die einfallende Solarstrahlung bzw. Solarenergie auf ein Photovoltaikelement der Solarvorrichtung gelenkt und/oder konzentriert werden kann.

Unter dem Begriff "Solarenergie" wird hier die Energie der von der Sonne kommenden Solarstrahlung sowie ganz allgemein die Energie elektromagnetischer Strahlung (z.B. von Licht) verstanden.

Wenn elektromagnetische Strahlung (z.B. Solarstrahlung) auf das Solarelement trifft, erwärmt sich dieses (z.B. auch im Winter, d.h. bei geringen Außentemperaturen); wobei sich Photovoltaikzellen bei intensiver Sonneneinstrahlung auf Temperaturen von ca. 80 °C oder mehr erwärmen können, sodass sich zwischen dem Solarelement und der Außenumgebung Temperaturdifferenzen von mehreren 10 K ergeben können.

Das Peltierelement kann z.B. mit (lediglich) einer seiner Thermoflächen in thermischer Verbindung mit dem Solarelement stehen, etwa indem die erste Thermofläche - z.B. mittels einer Wärmeleitpaste - in thermischem Kontakt mit dem Solarelement angeordnet ist (z.B. flächig an einer Fläche des Solarelements anliegt), wohingegen die zweite Thermofläche der Außenumgebung ausgesetzt angeordnet ist und nicht in direktem Kontakt mit dem Solarelement steht. Somit kann die das (bei Lichteinfall auf das Solarelement) erwärmte Solarelement kontaktierende erste Thermofläche gegenüber der das Solarelement nicht (unmittelbar) kontaktierenden zweiten Thermofläche eine erhöhte Temperatur aufweisen. Andererseits kann - z.B. bei einer auf einem beheizten Gebäude angebrachten Solarvorrichtung - auch ein umgekehrter Temperaturverlauf vorliegen; z.B. kann im Winter bei schneebedecktem (und somit gekühltem) Solarelement die das Solarelement kontaktierende erste Thermofläche gegenüber der zweiten Thermofläche (die z.B. zwischen der ersten Thermofläche und dem beheizten Gebäude angeordnet ist) eine niedrigere Temperatur aufweisen. Als ein anderes Beispiel kann tagsüber (bei Sonneneinstrahlung) die das Solarelement kontaktierende erste Thermofläche gegenüber der das Solarelement nicht (unmittelbar) kontaktierenden zweiten Thermofläche eine erhöhte Temperatur aufweisen, wobei von dem Peltierelement ein Stromfluss mit einer entsprechenden ersten Stromrichtung erzeugt wird; wohingegen nachts (bei Dunkelheit) das Solarelement als Kühlkörper für die erste Thermofläche wirkt und von dem Gebäude die tagsüber durch die Sonneneinstrahlung aufgenommene Wärme abgegeben wird und die zweite Thermofläche aufheizt, sodass nunmehr die erste Thermofläche gegenüber der zweiten Thermofläche eine niedrigere Temperatur aufweist, wobei von dem Peltierelement ein Stromfluss mit einer der ersten Stromrichtung entgegengerichteten Stromrichtung erzeugt wird. Zwischen der ersten und der zweiten Thermofläche entsteht somit jeweils eine Temperaturdifferenz, wobei von dem Peltierelement ein entsprechender elektrischer Strom bereitgestellt werden kann, welcher über die beiden Anschlusselektroden des Peltierelements abgegriffen werden kann.

Die thermische Kontaktierung zwischen dem Peltierelement (bzw. dessen erster Thermofläche) und dem Solarelement kann z.B. durch Kontaktieren einer Außenfläche des Solarelements mit einem großflächigen Wärmetauschkörper (z.B. einer Metallfolie, etwa aus Kupfer oder Aluminium, oder einer Diamantbeschichtung) und Kontaktieren des Wärmetauschkörpers mit dem Peltierelement (bzw. dessen erster Thermofläche) erfolgen. Der Wärmetauschkörper kann z.B. aus einem Material mit einer hohen thermischen Leitfähigkeit bestehen; wobei die den Wärmetauschkörper kontaktierende erste Thermofläche gegenüber der Fläche des Wärmetauschkörpers (und gegenüber der Außenfläche des Solarelements) klein gehalten sein kann, da aufgrund der guten thermische Leitfähigkeit des Wärmetauschkörpers die gesamte von dem Wärmetauschkörper aufgenommene Wärmemenge dem Peltierelement zugeführt werden kann. Demgemäß kann vorgesehen sein, lediglich einen Teil der Außenfläche des Solarelements mit einem Peltierelement zu kontaktieren, wodurch die Kosten für die Herstellung der Solarvorrichtung geringer gehalten werden können.

Es kann auch vorgesehen sein, dass das Solarelement - z.B. in Form einer Photovoltaik-Schichtanordnung - direkt auf einer Kontaktfläche des Peltierelements (z.B. auf der ersten oder der zweiten Thermofläche des Peltierelements) aufgebracht ist und somit das Solarelement integral mit dem Peltierelement ausgebildet ist. Des Weiteren kann z.B. vorgesehen sein, das Solarelement - z.B. in Form einer Photovoltaik-Schichtanordnung - direkt auf einer Kühlvorrichtung der Solarvorrichtung aufgebracht ist.

Es kann vorgesehen sein, eine der Thermoflächen des Peltierelements an der Solarelement-Vorderseite oder an einer Seitenfläche des Solarelements im thermischen Kontakt mit der jeweiligen Seite anzuordnen. Zum Beispiel kann das Thermoelement bzw. dessen erste Thermofläche lichtdurchlässig ausgebildet sein (z.B. aus zumindest teilweise transparenten Materialien bestehen oder z.B. in einer offenen Netz- bzw. Gitterstruktur mit Lichtdurchgangsöffnungen ausgebildet sein) und an der Solarelement-Vorderseite im thermischen Kontakt mit derselben angeordnet sein.

Gemäß einer Ausführungsform ist die erste Thermokontakt-Fläche des Peltierelements (bzw. die Materialschicht, von der die erste Thermokontakt-Fläche gebildet wird, im Folgenden auch als erste Thermokontakt-Schicht bezeichnet) im thermischen Kontakt mit der Solarelement-Vorderseite an derselben angeordnet und derart ausgebildet, dass sie zumindest teilweise durchlässig für die Solarstrahlung ist (d.h. zumindest einen Teil der darauf einfallenden Solarstrahlung zu der Solarelement-Vorderseite hindurchlässt). Es kann auch vorgesehen sein, dass das gesamte Peltierelement derart ausgebildet ist, dass es zumindest teilweise durchlässig für die Solarstrahlung ist, und mit seiner ersten Thermofläche an der Solarelement-Vorderseite angeordnet ist. Es kann z.B. vorgesehen sein, die erste Thermofläche (bzw. die erste Thermokontakt-Schicht) des Peltierelements oder das gesamte Peltierelement derart auszubilden, dass davon 50% oder mehr der Intensität der darauf auftreffenden Solarstrahlung zu der Solarelement-Vorderseite hindurchgelassen werden.

Zum Beispiel kann vorgesehen sein, das Peltierelement derart auszubilden und anzuordnen, dass die Solarelement-Vorderseite von der ersten Thermofläche kontaktierend überdeckt wird, und dass die zweite Thermofläche (bzw. die dieselbe bildende zweite Thermokontakt-Schicht) nicht der ersten Thermofläche parallel gegenüberliegend gebildet ist - sondern z.B. entlang des Umfangsrandes der ersten Thermofläche verlaufend angeordnet ist - und somit nicht im Strahlengang der auf das Solarelement zulaufenden Solarstrahlung liegt. In diesem Fall genügt es, wenn die erste Thermofläche bzw. die erste Thermokontakt-Schicht lichtdurchlässig ausgebildet ist, wohingegen die zweite Thermofläche bzw. die zweite Thermokontakt-Schicht entweder lichtdurchlässig oder auch lichtundurchlässig ausgebildet sein kann.

Gemäß der vorliegenden Ausführungsform ist die Solarelement-Vorderseite mit einem Peltierelement versehen, wobei insbesondere bei Verwendung des Peltierelements als thermoelektrischer Generator ausgenutzt werden kann, dass sich die der Solarstrahlung zugewandte Solarelement-Vorderseite stärker erwärmen kann als die Solarelement-Rückseite und somit größere Temperaturdifferenzen zwischen den Thermoflächen des Peltierelements ermöglicht sein können.

Gemäß einer Ausführungsform ist die erste Thermofläche (bzw. die erste Thermokontakt-Schicht) lichtdurchlässig gestaltet, indem sie mit Lichtdurchgangsöffnungen bzw. Lichtdurchtrittsöffnungen ausgebildet ist. Analog kann vorgesehen sein, das gesamte Peltierelement lichtdurchlässig zu gestalten, indem es mit Lichtdurchtrittsöffnungen ausgebildet wird (d.h. mit durchgehenden Öffnungen, durch welche hindurch Solarstrahlung zu der Solarelement-Vorderseite passieren kann). Gemäß dieser Ausführungsform kann der von dem Peltierelement zu der Solarelement-Vorderseite hindurchgelassene Anteil der Solarstrahlung z.B. durch die Größe der Lichtdurchtrittsöffnungen bestimmt sein, wobei die erste Thermokontakt-Schicht bzw. das gesamte Peltierelement sowohl aus Materialien bestehen können, die für die Solarstrahlung transparent sind, als auch aus Materialien, die für die Solarstrahlung undurchdringlich sind.

Gemäß einer weiteren Ausführungsform ist die erste Thermofläche (bzw. die erste Thermokontakt-Schicht) lichtdurchlässig gestaltet, indem sie aus Materialien besteht, die für die Solarstrahlung (bzw. für den von dem Solarelement nutz- bzw. umwandelbaren Anteil der Solarstrahlung) zumindest teilweise transparent sind und die Solarstrahlung nicht vollständig absorbieren. Analog kann vorgesehen sein, das gesamte Peltierelement lichtdurchlässig zu gestalten, indem es aus Materialien besteht, die für die Solarstrahlung zumindest teilweise transparent sind. Gemäß dieser Ausführungsform kann der von dem Peltierelement zu der Solarelement-Vorderseite hindurchgelassene Anteil der Solarstrahlung z.B. durch das Absorptionsvermögen und das Transmissionsvermögen der ersten Thermokontakt-Schicht bzw. des Peltierelements bestimmt werden.

Zum Beispiel können die Materialien der ersten Thermokontaktschicht oder auch des gesamten Peltierelements derart gewählt sein, dass von ihnen der von dem Solarelement nutzbare (d.h. umwandelbare) Anteil der Solarstrahlung im Wesentlichen ungeschwächt transmittiert wird und der von dem Solarelement nicht nutzbare Anteil der Solarstrahlung im Wesentlichen absorbiert wird (und somit nicht zum Erhitzen des Solarelements beiträgt). Dadurch kann die Temperatur der ersten Thermofläche zusätzlich erhöht werden und - bei Verwendung des Peltierelements als thermoelektrischer Generator - eine entsprechend hohe Stromausbeute mittels des Peltierelements ermöglicht werden, wobei die freiwerdende thermische Energie in elektrische Energie umgewandelt und abgeführt wird.

Das Peltierelement ist (beim Betrieb als thermoelektrischer Generator) zum Erzeugen einer elektrischen Spannung (bzw. eines elektrischen Stromes) entsprechend der zwischen der ersten und der zweiten Thermokontakt-Fläche bestehenden Temperaturdifferenz eingerichtet, wobei diese Spannung über die Anschlusselektroden des Peltierelements abgegriffen werden kann.

Wie bereits erläutert, kann mittels der von dem Peltierelement in Form von elektrischem Strom erzeugten Energie die Energiebilanz bzw. der Wirkungsgrad der Solarvorrichtung verbessert werden. Außerdem kann das Peltierelement in dieser Verschaltung durch die (in Form des elektrischen Stromes) entzogene Wärmeenergie als Kühlvorrichtung für das Solarelement fungieren, wodurch z.B. zusätzlich die Stromausbeute eines als Photovoltaikelement bzw. Solarzelle ausgeführten Solarelements verbessert werden kann.

Die Solarvorrichtung ist zudem (beim Betrieb als Wärmepumpe) zum derartigen Beaufschlagen des Peltierelements mit einem elektrischen Strom (bzw. einer elektrischen Spannung) ausgebildet, dass die erste Thermokontakt-Fläche gegenüber der zweiten Thermokontakt-Fläche geheizt oder gekühlt wird. Durch Anlegen einer elektrischen Spannung (in der Regel einer Gleichspannung) an die beiden Anschlusselektroden des Peltierelements kann, abhängig von der Polung der angelegten Spannung, entweder Wärme von der zweiten zu der ersten Thermofläche oder aber von der ersten zu der zweiten Thermofläche gepumpt werden, wobei die erste Thermofläche gegenüber der zweiten Thermofläche entweder geheizt oder gekühlt wird. Bei einer solchen Verschaltung weisen die Thermoflächen des Peltierelements im lastfreien Betrieb (d.h. ohne Kontakt der Thermoflächen zu jeweiligen zu kühlenden bzw. zu erwärmenden Körpern) somit entsprechende unterschiedliche Temperaturen auf. Dementsprechend ist die Solarvorrichtung mittels ihrer elektronischen Regelbarkeit weltweit einsetzbar und kann z.B. sowohl in heißen als auch in kalten Regionen zur Energiebereitstellung verwendet werden und die jeweils vorherrschenden Temperaturunterschiede nutzen.

Es kann, etwa bei Vorliegen geringer Umgebungs- bzw. Außentemperaturen (z.B. unterhalb von 0 °C, etwa im Winter), z.B. vorgesehen sein, das Solarelement durch Beheizen der das Solarelement kontaktierenden ersten Thermofläche (z.B. kurzzeitig) zu erwärmen, um ein als Solarzelle ausgeführtes Solarelement durch Abtauen von einer darauf liegenden Schnee- oder Eisschicht zu befreien. Eine solche (die Solarstrahlung stark reflektierende) Schneeschicht kann unter Umständen wochenlang bestehen und das Solarelement von der Sonneneinstrahlung abschirmen. In einem solchen Fall kann es - trotz des Energiebedarfs zum Abtauen des Solarelements - hinsichtlich der Gesamtenergiebilanz sinnvoll sein, das Solarelement zum Freilegen des Solarelements zumindest kurzzeitig mittels des Peltierelements aufzuheizen.

Es kann jedoch auch, z.B. bei Vorliegen starker Sonneneinstrahlung, vorgesehen sein, durch Anlegen einer entsprechenden Spannung an das Peltierelement das Solarelement abzukühlen. Dies kann z.B. sinnvoll sein, wenn die Wirkungsgradsteigerung, die durch die Abkühlung eines als Solarzelle ausgeführten Solarelements erzielt wird, den zum Abkühlen erforderlichen Energiebedarf überkompensiert. Des Weiteren kann mittels einer solchen Kühlung z.B. auf einfache Art und Weise ein Überhitzungsschutz des Solarelements realisiert werden.

Der zum Betreiben des Peltierelements erforderliche Strom kann z.B. über das öffentliche Stromnetz bezogen werden, wobei jedoch - da das Stromnetz Wechselstrom bereitstellt, ein Peltierelement jedoch üblicherweise mit Gleichstrom betrieben wird - der Strom zunächst mittels eines Gleichrichters gleichgerichtet werden muss. Es kann jedoch auch vorgesehen sein, dass die Solarvorrichtung eine Batterie zum Speichern von elektrischem Strom zum Beaufschlagen des Peltierelements damit aufweist.

Gemäß einer weiteren Ausführungsform wird das Peltierelement- z.B. zum Beheizen oder Kühlen des Solarelements - mit dem von dem Solarelement erzeugten elektrischen Strom beaufschlagt.

Beispielsweise können zur Stromversorgung des Peltierelements die Ausgangsanschlüsse des Solarelements (z.B. eines Photovoltaikelements) mit den Anschlusselektroden des Peltierelements elektrisch verbunden sein. Gemäß dieser Ausführungsform ist - da Photovoltaikelemente bzw. Solarzellen bereits eine Gleichspannung bereitstellen - zur Stromversorgung des Peltierelements kein Gleichrichter mehr erforderlich. Des Weiteren kann gemäß dieser Ausführungsform auf eine externe Stromzuführung für die Solarvorrichtung verzichtet werden.

Die Solarvorrichtung weist mindestens einen Temperatursensor - zum Erfassen der Temperatur an einer oder mehreren Positionen des Solarelements und/oder des Peltierelements und/oder der Außenumgebung - und/oder mindestens einen Lichtsensor - zum Erfassen der Lichtintensität an einer oder mehreren Positionen des Solarelements und/oder des Peltierelements und/oder der Außenumgebung - auf, wobei die Solarvorrichtung ferner eine Steuereinheit aufweist, die derart eingerichtet ist, dass von ihr basierend auf den erfassten Temperatur-Werten und/oder den erfassten

Lichtintensität-Werten die Funktionalität des Peltierelements variiert werden kann.

Die Funktionalität des Peltierelements kann von der mit den Sensoren verbundenen Steuereinheit derart eingestellt werden, dass in Abhängigkeit von den erfassten Sensorwerten der Temperatursensoren und/oder der Lichtsensoren das Peltierelement entweder als Stromerzeuger fungiert (d.h. als thermoelektrischer Generator betrieben wird), als (aktive) Heizvorrichtung zum Beheizen des Solarelements fungiert, oder als (aktive) Kühlvorrichtung zum Kühlen des Solarelements fungiert; wobei die jeweilige Funktionalität des Peltierelements mittels der oben beschriebenen unterschiedlichen Verschaltungen des Peltierelements realisiert werden kann.

Zum Beispiel kann vorgesehen sein, dass mittels eines Temperatursensors die Temperatur des Solarelements erfasst wird und das Peltierelement - solange sich die Temperatur des Solarelements innerhalb eines vorgegebenen Temperaturintervalls befindet - als Stromerzeuger betrieben wird und - sobald die erfasste Temperatur oberhalb des vorgegebenen Temperaturintervalls liegt - als Kühlvorrichtung zum Kühlen des Solarelements betrieben wird, wobei z.B. ein zu starkes Erwärmen des Solarelements verhindert werden kann. Als ein anderes Beispiel können, etwa zum Detektieren einer abschirmenden Schneeschicht auf der Solarelement-Vorderseite, ein direkt an bzw. auf der Solarelement-Vorderseite angeordneter Lichtsensor und ein externer (z.B. überdachter und somit vor Schneebedeckung geschützter) Lichtsensor vorgesehen sein, wobei von der Steuereinheit mittels Vergleichs der von den beiden Lichtsensoren erfassten Lichtintensitäten (und z.B. unter Berücksichtigung der Temperatur des Solarelements und/oder der Außenumgebung) das Vorhandensein einer Schnee-, Eis- oder Tauschicht auf der Solarelement-Vorderseite erfasst werden kann und gegebenenfalls das Peltierelement zumindest kurzzeitig als Heizvorrichtung zum Erwärmen des Solarelements betrieben wird, so dass das Solarelement von der abschirmenden Schicht befreit wird.

Mittels einer solchen (z.B. programmierbaren) Steuereinheit können für unterschiedliche Wettersituationen jeweils optimale Konfigurationen der Solarvorrichtung ermöglicht werden, so dass z.B. sowohl der Wirkungsgrad als auch die Lebensdauer der Solarvorrichtung erhöht werden können.

Gemäß einer weiteren Ausführungsform ist die erste Thermokontakt-Fläche des Peltierelements im thermischen Kontakt mit dem Solarelement und die zweite Thermokontakt-Fläche im thermischen Kontakt mit einer Kühlvorrichtung angeordnet.

Mittels der Kühlvorrichtung kann die Kühlung (d.h. die Wärmeabgabe) der zweiten Thermofläche verstärkt werden, wobei - insbesondere bei Verwendung des Peltierelements zur Stromerzeugung - sowohl eine stärkere Kühlung des Solarelements als auch eine größere und zeitlich konstante Temperaturdifferenz zwischen der (bei Lichteinfall auf das Solarelement erwärmten) ersten Thermofläche und der zweiten Thermofläche ermöglicht wird.

Die Kühlvorrichtung kann als (passiver) Kühlkörper, der in gutem thermischem Kontakt zu der zweiten Thermofläche angeordnet ist, ausgebildet sein. Der Kühlkörper kann z.B. als Metallkörper, z.B. aus Aluminium oder Kupfer, ausgeführt sein, wobei zur Verbesserung des Wärmeübertrags (z.B. an die umgebende Luft) die der zweiten Thermofläche abgewandte Seite des Kühlkörpers mit einer offenen Struktur - z.B. gebildet aus Rippen, Lamellen oder Mikroröhrchen (z.B. mit einem Durchmesser von ungefähr 0,3 mm) - versehen sein kann oder etwa aus (z.B. offenporigem) Metallschaum gebildet sein kann.

Die Kühlvorrichtung kann auch als (aktiver) Wärmetauscher ausgebildet sein, wobei z.B. ein von einer Kühlflüssigkeit durchströmter Kühlkreislauf zur Kühlung der zweiten Thermofläche vorgesehen sein kann. Das Photovoltaikelement und das Peltierelement können dabei zur Stromerzeugung eingerichtet sein, wobei durch den Beitrag des Peltierelements die Gesamtstromausbeute gesteigert wird, und wobei zusätzlich dazu durch die Kühlung des Photovoltaikelements dessen Wirkungsgrad verbessert wird. Außerdem kann die in dem Wärmetauscher (beim Abkühlen der zweiten Thermofläche) erwärmte Kühlflüssigkeit zur Gewinnung thermischer Energie vorgesehen sein, z.B. zum Beheizen eines Gebäudes oder zur Warmwassergewinnung.

Gemäß einer weiteren Ausführungsform ist das Peltierelement in Form einer Folie ausgebildet. Es kann auch vorgesehen sein, ein mehrstufiges Peltierelement in Form eines Stapels aus mehreren Peltierelement-Folien auszubilden.

Beispielsweise kann das Peltierelement in Form einer (dünnen) Keramikfolie oder Polymerfolie (z.B. aus PMMA), die nach dem Seebeckeffekt als Thermogenerator zur Erzeugung elektrischer Energie fungiert (sog. Seebeck-Folie bzw. Thermogenerator-Folie), ausgebildet sein. Dabei bilden zwei dünne Teilfolien jeweils die erste und die zweite Thermofläche des folienförmigen Peltierelements, wobei zwischen diesen Teilfolien elektrische Leiter aus unterschiedlichen Materialien (in der Regel Halbleitermaterialien) derart angeordnet sind, dass sie bei Vorliegen eines Stromflusses (bzw. einer entsprechenden elektrischen Spannung) als Wärmepumpe wirken und somit, wie oben beschrieben, Wärme von einer der Thermoflächen zu der jeweils anderen Thermofläche pumpen. Die Verwendung von Peltierelementen in Form einer (dünnen) Folie ermöglicht aufgrund der Flexibilität solcher Folien das Anpassen an beliebig geformte Solarelemente und somit auch ein gutes thermisches Kontaktieren derselben. Des Weiteren sind solche Folien großflächig und kostengünstig herstellbar.

Eine kostengünstige Herstellung einer Seebeck-Keramikfolie ist z.B. möglich, indem eine Seite eines Substratträgers (z.B. eine unstrukturierte Folie aus Aluminiumoxid oder Aluminiumnitrid) mikro- oder nanostrukturiert wird, indem regelmäßige Vertiefungen (z.B. rechteckig, pyramidenförmig) in die Oberfläche eingebracht werden und anschließend die Vertiefungen mit n- bzw. p-leitendem Halbleitermaterial befüllt werden. Die Befüllung kann z.B. mittels Masken erfolgen, wobei jeweils eine Maske zum Befüllen der Vertiefungen mit dem n-leitenden und eine zweite Maske zum Befüllen der restlichen Vertiefungen mit dem p-leitenden Material vorgesehen sein kann.

Die Solarvorrichtung kann zudem optische Lichtlenkeinheiten, von denen Licht auf eine aktive Fläche des Solarelements geleitet wird, und optische Konzentratoren, von denen Licht aus einem großen Raumbereich aufgefangen und auf einen (demgegenüber) kleinen Raumbereich auf dem Solarelement gebündelt wird, aufweisen. Bei Verwendung optischer Konzentratoren kann eine besonders starke Erwärmung des Solarelements resultieren, so dass die von dem Peltierelement zur Stromerzeugung nutzbare Temperaturdifferenz besonders hoch ausfallen kann und somit eine hohe Stromausbeute ermöglicht werden kann. Des Weiteren kann bei solchen starken Erwärmungen der durch die Kühlung eines Photovoltaikelements hervorgerufene Wirkungsgradgewinn besonders hoch sein.

Gemäß einer weiteren Ausführungsform weist das Solarelement mehrere (z.B. rechteckige oder sechseckige) Solarelement-Segmente auf und das Peltierelement weist mehrere (z.B. rechteckige oder sechseckige) Peltierelement-Segmente auf, wobei zumindest eines der Peltierelement-Segmente an jeder seiner Seitenkanten an ein Solarelement-Segment angrenzt und/oder zumindest eines der Solarelement-Segmente an jeder seiner Seitenkanten an ein Peltierelement-Segment angrenzt. Es kann z.B. vorgesehen sein, die Solarelement-Segmente und die Peltierelement-Segemente jeweils rechteckig auszubilden und schachbrettmuster-artig anzuordnen (wobei die Felder bzw. Segmente des Schachbrettmusters jedoch nicht notwendig quadratisch sind, sondern allgemein rechteckig - z.B. quadratisch - sein können).

Gemäß dieser Ausführungsform können sowohl die Solarelement-Segmente als auch die Peltierelement-Segmente direkt der Solarstrahlung ausgesetzt sein, sodass z.B. die der Sonne zugewandten Abschnitte der Peltierelement-Segmente - zusätzlich zu der Erwärmung durch die an das jeweilige Peltierelement-Segment angrenzenden Solarelement-Segmente - direkt von der Solarstrahlung erwärmt werden können. Dadurch kann eine große Temperaturdifferenz zwischen den beiden Thermoflächen des Peltierelements ermöglicht sein. Zum Beispiel kann vorgesehen sein, dass jedes der Peltierelement-Segmente eine erste Thermokontakt-Segmentfläche und eine zweite Thermokontakt-Segmentfläche (zum thermischen Kontaktieren des jeweiligen Peltierelement-Segments, z.B. mit einem angrenzenden Solarelement-Segment) aufweist, wobei jede der ersten Thermokontakt-Segmentflächen an ihrem Umfangsrand im thermischen Kontakt zu den an das jeweilige Peltierelement-Segment angrenzenden Solarelement-Segmenten steht und derart angeordnet ist, dass sie direkt der Solarstrahlung ausgesetzt ist, wohingegen jede der zweiten Thermokontakt-Segmentflächen derart angeordnet ist, dass sie nicht im (unmittelbaren) Kontakt zu den an das jeweilige Peltierelement-Segment angrenzenden Solarelement-Segmenten steht und bezüglich der Einfallsrichtung der Solarstrahlung hinter der zugehörigen ersten Thermokontakt-Segmentfläche angeordnet ist.

Gemäß einer weiteren Ausführungsform weist die Solarvorrichtung ferner eine optische Fokussiervorrichtung auf, die derart ausgebildet ist, dass von ihr Solarstrahlung auf jedes der Peltierelement-Segmente (bzw. auf die erste Thermokontakt-Segmentfläche jedes der Peltierelement-Segmente) fokussiert wird. Gemäß dieser Ausführungsform kann eine hohe Temperatur der ersten Thermokontakt-Segmentflächen und somit auch eine hohe Temperaturdifferenz zwischen den beiden Thermokontakt-Segmentflächen jedes Peltierelement-Segments ermöglicht sein.

Zum Beispiel kann vorgesehen sein, die optische Fokussiervorrichtung mit mehreren Linsen (z.B. Mikrolinsen) auszubilden, wobei jedem Peltierelement-Segment eine Linse zugeordnet ist, die derart ausgebildet und angeordnet ist, dass von ihr Solarstrahlung auf das Peltierelement-Segment (bzw. dessen erste Thermokontakt-Segmentfläche) gebündelt wird.

Die schachbrettmuster-artige Gestaltung der Solarvorrichtung, welche ein direktes Aussetzen der Peltierelement-Segmente zu der Solarstrahlung ermöglicht, erlaubt das Erzeugen sehr hoher Temperaturen an den Peltierelementen (bzw. deren ersten Thermokontakt-Segmentflächen), wobei diese Temperaturen z.B. höher sein können als die für das Solarelement vorgegebenen Maximal-Temperaturen.

Es kann vorgesehen sein, die Peltierelement-Segmente bzw. deren Thermokontakt-Segmentflächen (bzw. die dieselben bildenden Thermokontakt-Segmentschichten) aus einer Keramik auszubilden. Keramiken können aufgrund ihrer Hitzebeständigkeit sehr hohe Temperaturen der Thermokontakt-Segmentflächen und somit auch hohe Temperaturunterschiede zwischen den Thermoflächen ermöglichen.

Gemäß einer weiteren Ausführungsform wird ein Fahrzeug (z.B. ein Land-, Luft, oder Wasserfahrzeug) mit einer Solarvorrichtung der oben beschriebenen Art bereitgestellt, wobei das Fahrzeug z.B. ein Weltraumfahrzeug sein kann.

Zum Beispiel kann die Solarvorrichtung mit einem als Photovoltaikelement ausgeführten Solarelement zum Bereitstellen von Strom in einem Elektro- oder Hybrid-Auto oder in einem mit Solarenergie betriebenen Flugzeug vorgesehen sein. Des Weiteren kann eine solche Solarvorrichtung z.B. zu Energiegewinnung auf einem Schiff, einem Flugzeug, einer Raumfähre oder einem Satelliten vorgesehen sein.

Die Erfindung wird im Folgenden anhand von Ausführungsbeispielen mit Bezugnahme auf die beiliegenden Zeichnungen erläutert, wobei gleiche oder ähnliche Merkmale mit gleichen Bezugszeichen versehen sind. In den Zeichnungen zeigen schematisch:
**Figur 1** eine Darstellung einer Solarvorrichtung gemäß einer Ausführungsform, nicht Teil der Erfindung
**Figur 2** eine Darstellung einer Solarvorrichtung gemäß einer weiteren Ausführungsform, nicht Teil der Erfindung
**Figur 3** eine Darstellung einer Solarvorrichtung gemäß einer Ausführungsform mit einem an der Vorderseite eines Solarelements angeordneten, lichtdurchlässigen Peltierlement,
**Figur 4A** eine Draufsicht einer Solarvorrichtung gemäß einer Ausführungsform mit einer schachbrettmuster-artigen Ausgestaltung, und
**Figur 4B** eine Schnittdarstellung der Solarvorrichtung gemäß Figur 4A.

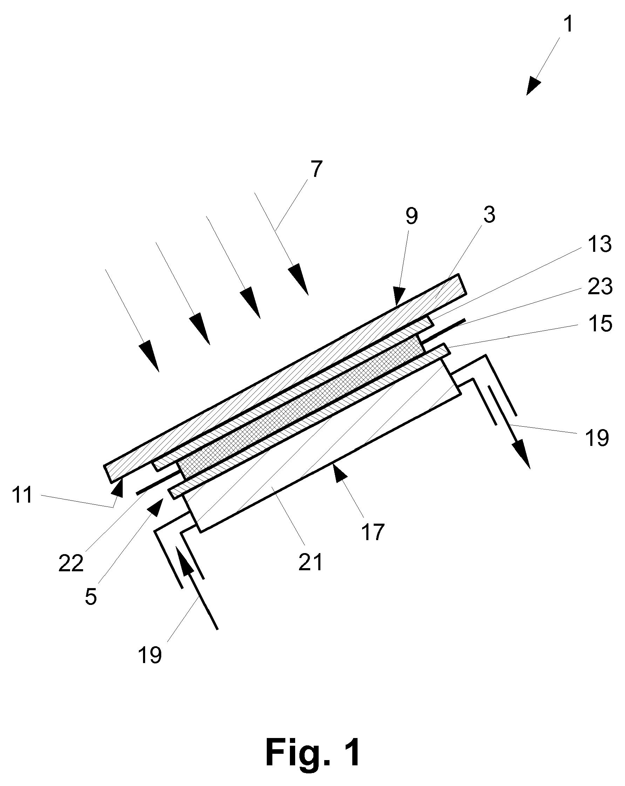

Figur 1 veranschaulicht eine Solarvorrichtung 1, nicht Teil der Erfindung, wobei die Solarvorrichtung zum Umwandeln von Solarenergie in elektrische Energie ausgebildet ist. Die Solarvorrichtung 1 weist ein Solarelement 3 in Form eines flächigen Photovoltaikelements bzw. einer Solarzelle 3 und ein Peltierelement 5 auf. Sonnenstrahlung 7 trifft auf die Vorderseite 9 des Photovoltaikelements 3 und wird von dem Photovoltaikelement 3 (zumindest teilweise) in elektrische Energie umgewandelt, wobei sich das Photovoltaikelement 3 zudem erwärmt. Das Peltierelement 5 ist im thermischen Kontakt mit dem Photovoltaikelement 3 an der Rückseite 11 desselben angeordnet und weist zwei Thermokontakt-Flächen bzw. Thermoflächen 13, 15 auf, mittels derer das Peltierelement 5 thermisch kontaktiert werden kann. Gemäß Fig. 1 ist das Peltierelement 5 mit seiner ersten Thermofläche 13 an der Rückseite 11 des Solarelements 3 flächig anliegend vorgesehen, wobei ein guter thermischer Kontakt zwischen dem Solarelement 3 (bzw. dessen Rückseite 11) und der ersten Thermofläche 13 z.B. mittels einer Wärmeleitpaste gewährleistet werden kann.

Die Solarvorrichtung 1 weist ferner eine Kühlvorrichtung 17 auf, die im thermischen Kontakt mit der zweiten Thermofläche 15 des Peltierelements 5 angeordnet ist. Gemäß Fig. 1 wird die zweite Thermofläche 15 als Beispiel mittels einer (entsprechend temperierten) Kühlflüssigkeit 19, die einen im thermischen Kontakt mit der zweiten Thermofläche 15 stehenden Wärmetauschkörper 21 der Kühlvorrichtung 17 durchströmt, derart gekühlt, dass sie eine (wesentlich) geringere Temperatur aufweist als die erste Thermofläche 13, die das (von der Sonneneinstrahlung erwärmte) Solarelement 3 kontaktiert. In Fig. 1 ist die in den Wärmetauschkörper 21 einströmende bzw. aus demselben herausströmende Kühlflüssigkeit 19 durch die Pfeile 19 veranschaulicht. Bei Verwendung von Wasser als Kühlflüssigkeit 19 kann die Solarvorrichtung 1 somit zusätzlich zur Warmwassergewinnung verwendet werden, wodurch die Gesamtenergiebilanz zusätzlich verbessert wird.

Gemäß Fig. 1 ist das Peltierelement 5 zur Stromerzeugung eingerichtet, wobei der von dem Peltierelement 5 aufgrund der zwischen den beiden Thermoflächen 13 und 15 bestehenden Temperaturdifferenz erzeugte elektrische Strom über die beiden Anschlusselektroden 22, 23 des Peltierelements 5 abgegriffen werden kann. Des Weiteren ist die Solarvorrichtung 1 zum Beaufschlagen der Anschlusselektroden 22, 23 des Peltierelements 5 mit einem elektrischen Strom derart ausgebildet, dass das Peltierelement 5 als Wärmepumpe zum selektiven Heizen und Kühlen des Solarelements 3 betreibbar ist. Die Solarvorrichtung 1 weist einen Temperatursensor (nicht dargestellt) zum Erfassen der Temperatur des Solarelements 3 auf. Zudem weist die Solarvorrichtung 1 eine Steuereinheit (nicht dargestellt) auf, die derart eingerichtet ist, dass von ihr basierend auf der von dem Temperatursensor erfassten Temperatur die Funktionalität des Peltierelements 5 derart variiert wird, dass dasselbe selektiv einerseits entweder als thermoelektrischer Generator oder andererseits als Wärmepumpe zum wahlweisen Heizen oder Kühlen des Solarelements 3 betrieben wird; wobei beim Betreiben des Peltierelements 5 als Wärmepumpe zum Heizen bzw. Erwärmen des Solarelements 3 z.B. der Strom der Kühlflüssigkeit 19 unterbrochen bzw. angehalten werden kann.

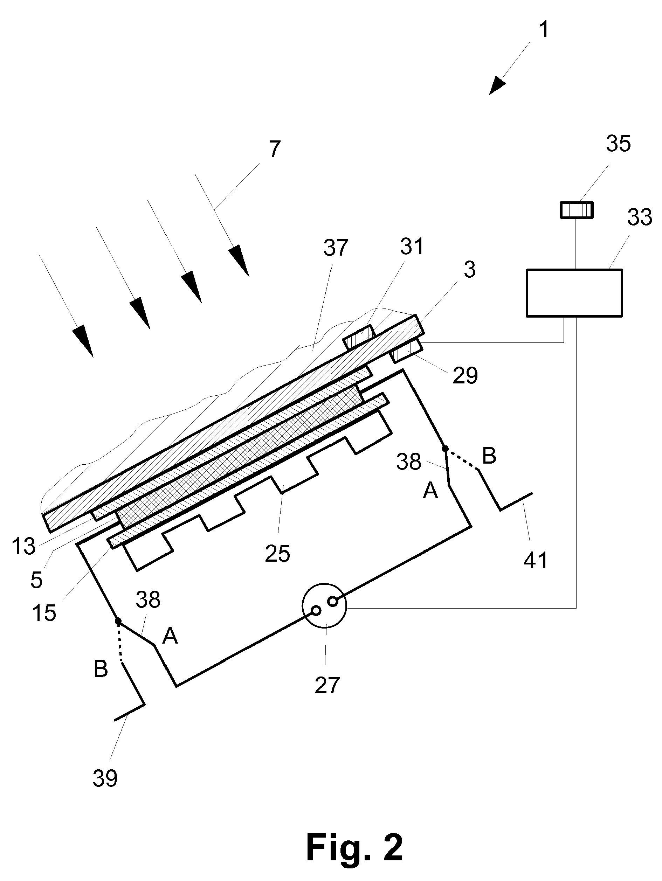

Figur 2 veranschaulicht eine Solarvorrichtung 1 gemäß einer weiteren Ausführungsform, nicht Teil der Erfindung. Die Solarvorrichtung 1 gemäß Fig. 2 gleicht im Aufbau prinzipiell der Solarvorrichtung 1 gemäß Fig. 1, wobei jedoch gemäß Fig. 2 anstelle der flüssigkeitsbasierten (aktiven) Kühlvorrichtung 17 eine (passive) Kühlung mittels eines gerippten Kühlkörpers 25 vorgesehen ist, der im thermischen Kontakt zu der zweiten Thermofläche 15 des Peltierelements 5 angeordnet ist. Des Weiteren ist die Solarvorrichtung 1 gemäß Fig. 2 derart eingerichtet, dass das Peltierelement 5 bei Bedarf als Wärmepumpe zum Kühlen und/oder Erwärmen des Photovoltaikelements 3 eingesetzt werden kann. Zu diesem Zweck weist die Solarvorrichtung 1 gemäß Fig. 2 eine steuerbare Gleichspannungsquelle 27 auf.
Bei der Ausführungsform gemäß Fig. 2 sind ferner ein Temperatursensor 29 an der Rückseite 11 und ein Lichtintensitätssensor bzw. Helligkeitssensor 31 an der Vorderseite 9 des Photovoltaikelements 3 angeordnet. Des Weiteren ist eine Steuereinheit 33 vorgesehen, die mit der steuerbaren Spannungsquelle 27, dem Temperatursensor 29 und dem Helligkeitssensor 31 verbunden ist (wobei die Verbindung zu dem Helligkeitssensor 31 nicht dargestellt ist). Die Steuereinheit 33 ist außerdem mit einem externen Referenz-Lichtintensitätssensor 35 verbunden.
Die Steuereinheit 33 ist derart eingerichtet, dass von ihr basierend auf dem von dem Temperatursensor 29 erfassten Temperaturwert und den von den Lichtsensoren 31, 35 erfassten Lichtintensitätswerten das Peltierelement 5 entweder zur Stromerzeugung oder als Temperiervorrichtung zum Temperieren (d.h. Kühlen oder Erwärmen) des Solarelements 3 verschaltet werden kann.
Beispielsweise kann die Steuereinheit 33 zum Detektieren einer Schneebedeckung 37 auf der Vorderseite 9 des Photovoltaikelements 3 mittels Vergleichs der von den Helligkeitssensoren 31 und 35 erfassten Helligkeitswerte unter Einbeziehung des von dem Temperatursensor 29 erfassten Wertes eingerichtet sein. Eine solche Schneeschicht 37 reflektiert einen Großteil der Solarstrahlung 7 und vermindert daher die Stromausbeute des Photovoltaikelements 3 massiv. Im Falle einer solchen Schneebedeckung werden mittels der Steuereinheit 33 die Anschlusselektroden 22, 23 des Peltierelements 5 mit der Gleichspannungsquelle 27 verbunden (in Fig. 2 veranschaulicht durch die Schalterstellung Ader Umschalter 38) und die Polung (und z.B. der Betrag der bereitgestellten Spannung) der Spannungsquelle 27 derart eingestellt, dass die erste Thermofläche 13 gegenüber der zweiten Thermofläche 15 erwärmt wird, die erste Thermofläche 13 also als Heizelement zum Erwärmen des Photovoltaikelements 3 fungiert und dieses somit durch Abtauen von der Schneebedeckung 37 befreit werden kann. Wenn von der Steuereinheit 33 mittels der erfassten Sensorwerte der Sensoren 29, 31, 35 ermittelt wird, dass keine abschirmende Schneebedeckung (mehr) auf der Solarelement-Vorderseite 9 vorhanden ist, werden hingegen mittels der Steuereinheit 33 die Anschlusselektroden 22, 23 des Peltierelements 5 mit zwei Stromabgriff-Elektroden 39, 41 verbunden (in Fig. 2 veranschaulicht durch die Schalterstellung B) und das Peltierelement 5 als Stromerzeuger betrieben.

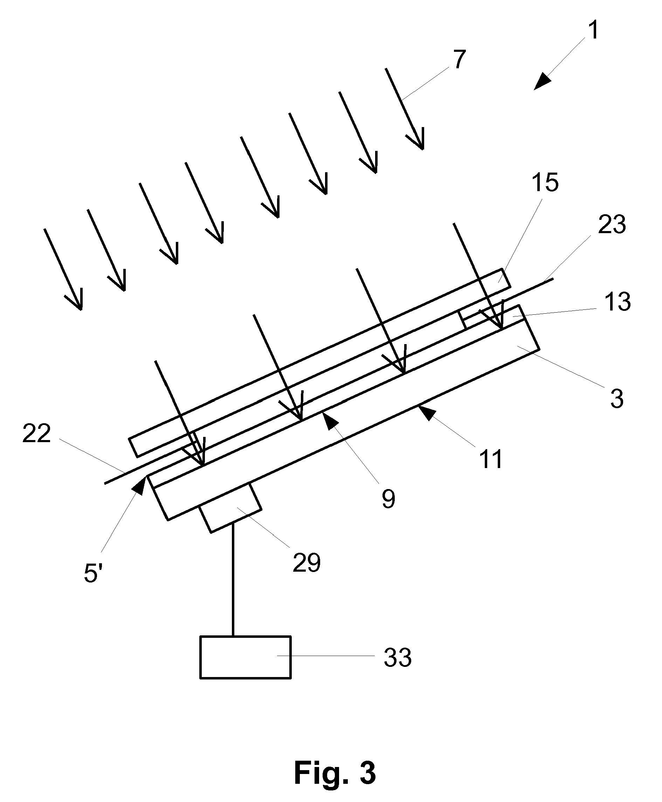

Figur 3 veranschaulicht eine Solarvorrichtung 1 gemäß einer weiteren Ausführungsform, wobei die Solarvorrichtung 1 ein an der Solarelement-Vorderseite 9 eines Solarelements 3 angeordnetes, lichtdurchlässiges Peltierelement 5' aufweist. Insbesondere weist das Peltierelement 5' als Beispiel eine lichtdurchlässige erste Thermofläche bzw. Thermokontakt-Schicht 13 und eine lichtdurchlässige zweite Thermofläche bzw. Thermokontakt-Schicht 15 auf und steht mit seiner ersten Thermofläche 13 im thermischen Kontakt mit der Solarelement-Vorderseite 9. Wie mittels der Halbierung der Anzahl der Pfeile 7, welche die Solarstrahlung veranschaulichen, dargestellt, ist das Peltierelement 5' derart ausgebildet, dass von ihm 50% der Intensität der darauf einfallenden Solarstrahlung zu der Solarelement-Vorderseite 9 hindurchgelassen werden. Im vorliegenden Fall wird dies realisiert, indem das Peltierelement 5' die gesamte Solarelement-Vorderseite 9 überspannt und Lichtdurchtrittsöffnungen (nicht dargestellt) aufweist, wobei die GesamtQuerschnittsfläche der Lichtdurchtrittsöffnungen 50% der Fläche der Solarelement-Vorderseite 9 beträgt. Alternativ dazu kann auch vorgesehen sein, dass das Peltierelement 5' aus Materialien besteht, welche die Solarstrahlung 7 nicht vollständig absorbieren und zumindest einen Teil (hier als Beispiel 50%) der Intensität der darauf einfallenden Solarstrahlung 7 transmittieren.

Die Solarvorrichtung 1 gemäß Figur 3 weist ferner einen an der Solarelement-Rückseite 11 angeordneten Temperatursensor 29 und eine Steuereinheit 33 auf, wobei die Steuereinheit 33 derart eingerichtet ist, dass von ihr basierend auf dem von dem Temperatursensor 29 erfassten Temperaturwert das Peltierelement 5' entweder als thermoelektrischer Generator zur Stromerzeugung oder als Wärmepumpe zum Temperieren (d.h. wahlweisen Kühlen oder Erwärmen) des Solarelements 3 verschaltet wird.

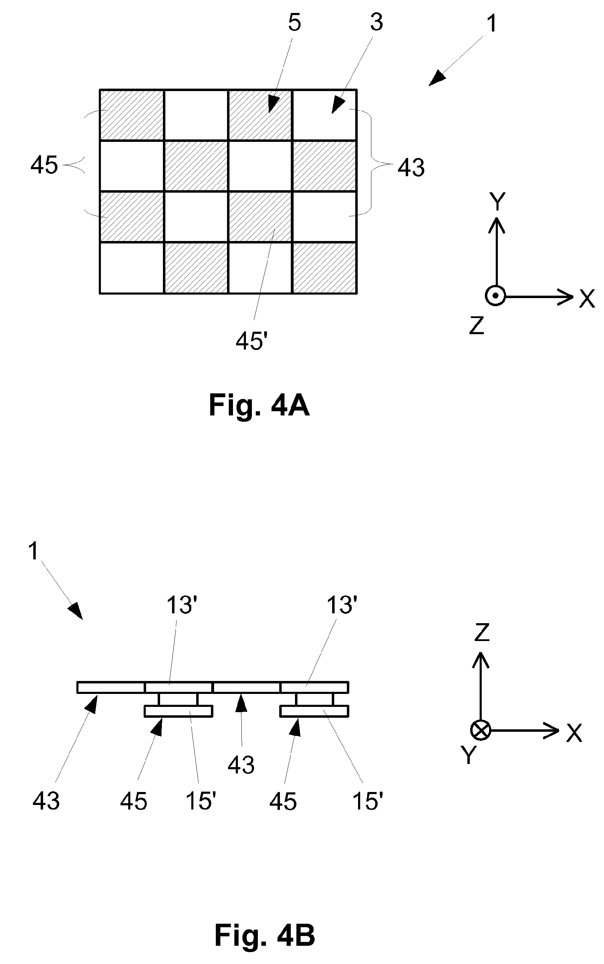

Die Figuren 4A und 4B veranschaulichen eine Solarvorrichtung 1 gemäß einer weiteren Ausführungsform, wobei das Solarelement 3 mehrere rechteckige Solarelement-Segmente 43 (in der Draufsicht gemäß Fig. 4A veranschaulicht durch die nichtschraffierten Rechtecke) und das Peltierelement 5 mehrere rechteckige Peltierelement-Segmente 45 (in Fig. 4A veranschaulicht durch die schraffierten Rechtecke) aufweist. Die Solarelement-Segmente 43 und die Peltierelement-Segemente 45 sind schachbrettmuster-artig angeordnet, wobei z.B. das Peltierelement-Segment 45' an jeder seiner vier Rechteck-Seitenkanten an ein Solarelement-Segment 43 angrenzt.

Wie in Figur 4B - welche einen Schnitt durch die Solarvorrichtung gemäß Fig. 4A veranschaulicht, der parallel zur zx-Ebene des in den Figuren 4A und 4B dargestellten xyz-Koordinatensystems verläuft - weist jedes der Peltierelement-Segmente 45 eine erste Thermokontakt-Segmentfläche 13' und eine zweite Thermokontakt-Segmentfläche 15' zum thermischen Kontaktieren des jeweiligen Peltierelement-Segments 45 auf; wobei jede der ersten Thermokontakt-Segmentflächen 13' im thermischen Kontakt zu den umgebenden Solarelement-Segmenten 43 steht und mit denselben eine ebene Fläche bzw. Vorderseite zum Auftreffen von Solarstrahlung darauf ausbildet, wohingegen die zweiten Thermokontakt-Segmentflächen 15' nicht im thermischen Kontakt zu den Solarelement-Segmenten 43 stehen. Die erste Thermofläche 13 des Peltierelements 5 ist von den ersten Thermokontakt-Segmentflächen 13' gebildet, die zweite Thermofläche 15 des Peltierelements 5 ist von den zweiten Thermokontakt-Segmentflächen 15' gebildet. Die Thermokontakt-Segmentflächen 13', 15' bzw. die dieselben bildenden Thermokontakt-Segmentschichten bestehen als Beispiel aus einem keramischen Material.

Die Solarvorrichtung 1 gemäß den Figuren 4A und 4B weist zudem einen Temperatursensor (nicht dargestellt) zum Erfassen der Temperatur des Solarelements 3 bzw. der Solarelement-Segmente 43 auf. Des Weiteren weist die Solarvorrichtung 1 eine Steuereinheit (nicht dargestellt) auf, die derart eingerichtet ist, dass von ihr basierend auf der von dem Temperatursensor erfassten Temperatur die Funktionalität des Peltierelements 5 bzw. der Peltierelement-Segmente 45 derart variiert wird, dass diese selektiv einerseits entweder als thermoelektrischer Generator oder andererseits als Wärmepumpe zum wahlweisen Heizen oder Kühlen des Solarelements 1 betrieben werden.

### Liste der verwendeten Bezugszeichen

- 1: Solarvorrichtung
- 3: Solarelement/Photovoltaikelement
- 5, 5': Peltierelement
- 7: Solarstrahlung
- 9: Vorderseite des Photovoltaikelements
- 11: Rückseite des Photovoltaikelements
- 13: erste Thermokontakt-Fläche des Peltierelements
- 13': erste Thermokontakt-Segmentflächen der Peltierelement-Segmente
- 15: zweite Thermokontakt-Fläche des Peltierelements
- 15': zweite Thermokontakt-Segmentflächen der Peltierelement-Segmente
- 17: Kühlvorrichtung
- 19: Kühlflüssigkeit
- 21: Wärmetauschkörper
- 22: Anschlusselektrode des Peltierelements
- 23: Anschlusselektrode des Peltierelements
- 25: Kühlkörper
- 27: Gleichspannungsquelle
- 29: Temperatursensor
- 31: Lichtintensitätssensor
- 33: Steuereinheit
- 35: Referenz-Lichtintensitätssensor
- 37: Schneebedeckung
- 38: Umschalter
- 39: Stromabgriff-Elektrode
- 41: Stromabgriff-Elektrode
- 43: Solarelement-Segmente
- 45, 45': Peltierelement-Segmente

## Patentansprüche

1. Solarvorrichtung (1) mit einem Solarelement (3), das zum Umwandeln von Solarenergie in elektrische Energie ausgebildet ist, und einem Peltierelement (5, 5') mit einer ersten (13) und einer zweiten (15) Thermokontakt-Fläche, das im thermischen Kontakt mit dem Solarelement (3) angeordnet ist, wobei die Solarvorrichtung zum derartigen Beaufschlagen des Peltierelements mit einem elektrischen Strom ausgebildet ist, dass das Peltierelement als Wärmepumpe zum selektiven Heizen und Kühlen des Solarelements (3) betreibbar ist, und wobei die Solarvorrichtung (1) einen Temperatursensor (29) und/oder einen Lichtsensor (31, 35) aufweist, **dadurch gekennzeichnet, dass** die Solarvorrichtung (1) derart ausgebildet ist, dass das Peltierelement als thermoelektrischer Generator zum Erzeugen einer elektrischen Spannung betreibbar ist und die erzeugte Spannung über Anschlusselektroden (22, 23) des Peltierelements abgreifbar ist, wobei die Solarvorrichtung (1) eine Steuereinheit (33) aufweist, die derart eingerichtet ist, dass von ihr basierend auf der von dem Temperatursensor (29) erfassten Temperatur und/oder der von dem Lichtsensor (31, 35) erfassten Lichtintensität die Funktionalität des Peltierelements (5, 5') derart variierbar ist, dass das Peltierelement (5) selektiv entweder als thermoelektrischer Generator zum Erzeugen einer elektrischen Spannung oder als Wärmepumpe zum selektiven Heizen und Kühlen des Solarelements betreibbar ist, und wobei das Solarelement (3) eine Solarelement-Vorderseite (9) zum Auftreffen von Solarstrahlung darauf und eine von derselben abgewandte Solarelement-Rückseite (11) aufweist, und wobei die erste Thermokontakt-Fläche (13) des Peltierelements (5) derart ausgebildet ist, dass sie zumindest teilweise durchlässig für die Solarstrahlung ist, und im thermischen Kontakt mit der Solarelement-Vorderseite (9) angeordnet ist.

2. Solarvorrichtung nach Anspruch 1, wobei die erste Thermokontakt-Fläche (13) des Peltierelements (5') Lichtdurchgangsöffnungen zum Hindurchlassen von Solarstrahlung aufweist.

3. Solarvorrichtung nach Anspruch 1, wobei die erste Thermokontakt-Fläche (13) aus Materialien besteht, die für die Solarstrahlung zumindest teilweise transparent sind.

4. Solarvorrichtung nach Anspruch 1, wobei das Solarelement (3) mehrere Solarelement-Segmente (43) aufweist und das Peltierelement (5) mehrere Peltierelement-Segmente (45) aufweist, und wobei zumindest eines der Peltierelement-Segmente (45') an jeder seiner Seitenkanten an ein Solarelement-Segment angrenzt und/oder zumindest eines der Solarelement-Segmente an jeder seiner Seitenkanten an ein Peltierelement-Segment angrenzt.

5. Solarvorrichtung nach Anspruch 4, wobei die Solarvorrichtung eine optische Fokussiervorrichtung aufweist, die derart ausgebildet ist, dass von ihr Solarstrahlung auf jedes der Peltierelement-Segmente (45) fokussiert wird.

6. Solarvorrichtung nach einem der Ansprüche 1 bis 5, wobei das Peltierelement (5, 5') bei Funktion als Wärmepumpe zum selektiven Heizen oder Kühlen des Solarelements mit dem von dem Solarelement erzeugten elektrischen Strom beaufschlagt wird.

7. Solarvorrichtung nach einem der Ansprüche 1 bis 6, wobei die erste Thermokontakt-Fläche (13) im thermischen Kontakt mit dem Solarelement (3) angeordnet ist und die zweite Thermokontakt-Fläche (15) im thermischen Kontakt mit einer Kühlvorrichtung (17, 25) angeordnet ist.

8. Solarvorrichtung nach einem der Ansprüche 1 bis 7, wobei das Peltierelement (5, 5') in Form einer Folie ausgebildet ist.

9. Fahrzeug, **dadurch gekennzeichnet, dass** das Fahrzeug eine Solarvorrichtung (1) gemäß einem der Ansprüche 1 bis 8 aufweist.

10. Fahrzeug nach Anspruch 9, wobei das Fahrzeug ein Weltraumfahrzeug ist.

## Claims

1. A solar device (1), comprising a solar element (3) designed to convert solar energy into electric energy, and a Peltier element (5, 5'), which has a first (13) and a second (15) thermal contact surface and is disposed in thermal contact with the solar element (3), the solar device being designed to supply the Peltier element with an electric current such that the Peltier element can be operated as a heat pump for selectively heating and cooling the solar element (3), and the solar device (1) comprising a temperature sensor (29) and/or a light sensor (31, 35), **characterized in that** the solar device (1) is designed in such a way that the Peltier element can be operated as a thermoelectric generator for generating a voltage, and the generated voltage can be tapped via connecting electrodes (22, 23) of the Peltier element, the solar device (1) comprising a control unit (33), which is configured so as to be able to vary the functionality of the Peltier element (5, 5'), based on the temperature detected by the temperature sensor (29) and/or the light intensity detected by the light sensor (31, 35), in such a way that the Peltier element (5) can be selectively operated either as a thermoelectric generator for generating a voltage or as a heat pump for selectively heating and cooling the solar element, and the solar element (3) comprising a solar element front side (9) for solar radiation to impinge thereon and a solar element back side (11) facing away from the same, and the first thermal contact surface (13) of the Peltier element (5) being designed so as to be at least partially pervious to the solar radiation and disposed in thermal contact with the solar element front side (9).

2. The solar device according to claim 1, wherein the first thermal contact surface (13) of the Peltier element (5') comprises light through-passages to allow solar radiation to pass through.

3. The solar device according to claim 1, wherein the first thermal contact surface (13) is made of materials that are at least partially transparent to the solar radiation.

4. The solar device according to claim 1, wherein the solar element (3) comprises a plurality of solar element segments (43), and the Peltier element (5) comprises a plurality of Peltier element segments (45), and at least one of the Peltier element segments (45') on each of the side edges thereof adjoins a solar element segment and/or at least one of the solar element segments on each of the side edges thereof adjoins a Peltier element segment.

5. The solar device according to claim 4, wherein the solar device comprises an optical focusing device, which is designed so as to focus solar radiation onto each of the Peltier element segments (45).

6. The solar device according to any one of claims 1 to 5, wherein the Peltier element (5, 5'), when functioning as a heat pump for selectively heating or cooling the solar element, is supplied the electric current generated by the solar element.

7. The solar device according to any one of claims 1 to 6, wherein the first thermal contact surface (13) is disposed in thermal contact with the solar element (3), and the second thermal contact surface (15) is disposed in thermal contact with a cooling device (17, 25).

8. The solar device according to any one of claims 1 to 7, wherein the Peltier element (5, 5') is designed in the form of a foil.

9. A vehicle, **characterized by** comprising a solar device (1) according to any one of claims 1 to 8.

10. The vehicle according to claim 9, wherein the vehicle is a spacecraft.

## Revendications

1. Dispositif solaire (1) avec un élément solaire (3) qui est conçu pour la transformation d'énergie solaire en énergie électrique, et un élément de Peltier (5, 5') avec une première (13) et une seconde (15) surface de thermo-contact, qui est disposé en contact thermique avec l'élément solaire (3), où le dispositif solaire est conçu pour l'alimentation de l'élément Peltier avec un courant électrique de telle manière que l'élément de Peltier peut être mis en oeuvre sous la forme d'une pompe à chaleur pour le chauffage sélectif ou le refroidissement de l'élément solaire (3), et où le dispositif solaire (1) présente un capteur de température (29) et/ou un capteur de lumière (31, 35), **caractérisé en ce que** le dispositif solaire (1) est conçu de telle façon que l'élément de Peltier peut être mis en oeuvre en tant que générateur thermoélectrique pour la création d'une tension électrique et la tension créée peut être mesurée par l'intermédiaire d'électrodes de raccordement (22, 23) de l'élément de Peltier, où le dispositif solaire (1) présente une unité de commande (33) qui est installée de telle manière que la fonctionnalité de l'élément de Peltier (5, 5') peut être variée par elle sur la base de la température détectée par le capteur de température (29) et/ou l'intensité lumineuse détectée par le capteur de lumière (31, 35) de telle sorte que l'élément de Peltier (5) peut être mis en oeuvre sélectivement soit en que générateur thermoélectrique pour la création d'une tension électrique, soit en tant que pompe à chaleur pour le chauffage sélectif et le refroidissement de l'élément solaire, et où l'élément solaire (3) présente une face avant d'élément solaire (9) pour la capture du rayonnement solaire sur le dessus et une face arrière d'élément solaire (11) opposée à celle-ci, et où la première surface de thermo-contact (13) de l'élément de Peltier (5) est conçue de telle manière qu'elle est au moins partiellement perméable pour le rayonnement solaire, et est disposée en contact thermique avec la face avant de l'élément solaire (9).

2. Dispositif solaire selon la revendication 1, où la première surface de thermo-contact (13) de l'élément de Peltier (5') présente des ouvertures de passage de lumière pour la traversée du rayonnement solaire.

3. Dispositif solaire selon la revendication 1, où la première surface de thermo-contact (13) est constituée de matériaux qui sont au moins partiellement transparents pour le rayonnement solaire.

4. Dispositif solaire selon la revendication 1, où l'élément solaire (3) présente plusieurs segments d'élément solaire (43) et l'élément de Peltier (5) présente plusieurs segments d'éléments de Peltier (45) et où au moins un des segments d'élément de Peltier (45') est limitrophe avec chacune de ses arêtes latérales avec un segment d'élément solaire et/ou au moins un des segments d'élément solaire est limitrophe avec chacune de ses arêtes latérales avec un segment d'élément de Peltier.

5. Dispositif solaire selon la revendication 4, où le dispositif solaire présente un dispositif de focalisation optique qui est conçu de telle manière qu'il provoque la focalisation du rayonnement solaire sur chacun des segments de l'élément de Peltier (45).

6. Dispositif solaire selon l'une des revendications 1 à 5, où l'élément de Peltier (5, 5') en fonction est mis en oeuvre sous forme de pompe à chaleur pour le chauffage sélectif ou le refroidissement de l'élément solaire avec le courant électrique généré par l'élément solaire.

7. Dispositif solaire selon l'une des revendications 1 à 6, où la première surface de thermo-contact (13) est disposée en contact thermique avec l'élément solaire (3) et la deuxième surface de thermo-contact (15) est disposée en contact thermique avec un dispositif de refroidissement (17, 25).

8. Dispositif solaire selon l'une des revendications 1 à 7, où l'élément de Peltier (5, 5') est conçu sous la forme d'un film.

9. Véhicule **caractérisé en ce que** le véhicule présente un dispositif solaire (1) selon l'une des revendications 1 à 8.

10. Véhicule selon la revendication 9, où le véhicule est un véhicule spatial.
